# EUROPÄISCHE PATENTSCHRIFT

(11) **EP 1 299 948 B1**
(45) Veröffentlichungstag und Bekanntmachung des Hinweises auf die Patenterteilung: **20.07.2005**
(21) Anmeldenummer: 01940400.3
(22) Anmeldetag: 04.05.2001
(51) Int. Cl.: H03H 11/48

(54) **SPANNUNGSGESTEUERTE KAPAZITÄT**
VOLTAGE-CONTROLLED CAPACITOR
CAPACITE COMMANDEE EN TENSION

(30) Priorität: 05.05.2000 DE 10021867
(43) Veröffentlichungstag der Anmeldung: 09.04.2003
(73) Patentinhaber: Infineon Technologies AG, 81669 München (DE)
(72) Erfinder: TIEBOUT, Marc, 81739 München (DE)
(74) Vertreter: Ginzel, Christian
(86) Internationale Anmeldenummer: PCT/EP2001/005035
(87) Internationale Veröffentlichungsnummer: WO 2001/086807

(56) Entgegenhaltungen:
- US-A- 3 808 517

## Beschreibung

Die Erfindung betrifft eine spannungsgesteuerte Kapazität.

Die bekannten spannungsabhängigen Kapazitäten (Varaktoren) werden insbesondere in spannungsgesteuerten Oszillatoren (Voltage Controlled Oscillators - VCOs) eingesetzt.

Gattungsgemäße gesteuerte Kapazitäten sind beispielsweise in Jan Craninckx and M.S. J. Steyaert, "A 1.8GHz CMOS Low-Phase-Noise Voltage-Controlled Oscillator with Prescaler", IEEE Journal of Solid-State Circuits,Vol. 30, No.12, Dec.1995, und in
P. Andreani, "A Comparison between Two 1.8GHz CMOS VCOs Tuned by Different Varactors", in Proc. of the European Solid-State Circuits Conference (ESSCIRC'98), pp. 380-383, The Hague, Sept. 1998 dargestellt. In US-A-3 808 517 wird eine spannungsabhängige Kapazität offenbart, die zwei parallel geschaltete Varaktoren umfasst.

Spannungsgesteuerte Oszillatoren weisen die Besonderheit auf, dass ihre Frequenz durch eine an ihnen anliegende Spannung gesteuert werden kann. Bei einem Einsatz im Hochfrequenzbereich kann eine Abstimmung ihres Schwingungsverhaltens durch eine spannungsgesteuerte Kapazität, d.h. einen Varaktor, erfolgen.

Der Erfindung liegt die Aufgabe zugrunde, eine spannungsgesteuerte Kapazität zu schaffen, die eine möglichst geringe Störempfindlichkeit aufweist.

Erfindungsgemäß wird diese Aufgabe dadurch gelöst, dass eine spannungsgesteuerte Kapazität so ausgestattet wird, dass sie zwei parallel geschaltete Varaktoren enthält, die so geschaltet sind, dass die Kapazität durch Differenzsignale gesteuert wird.

Hierbei ist es zweckmäßig dass die Kapazität durch Differenzsignale zwischen den beiden Varaktoren gesteuert wird.

Es ist vorteilhaft, die spannungsteuerte Kapazität so zu gestalten, dass der eine Varaktor eine nmos-Schichtenfolge enthält und dass der andere der Varaktoren eine pmos-Schichtenfolge enthält.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt
- Fig. 1: einen spannungsgesteuerten Varaktor,
- Fig. 2: einen differentiell gesteuerten Varaktor,
- Fig. 3: eine Schaltskizze eines differentiell gesteuerten MOS-Varaktors und
- Fig. 4: einen differentiell gesteuerten Floating MOS-Varaktor.

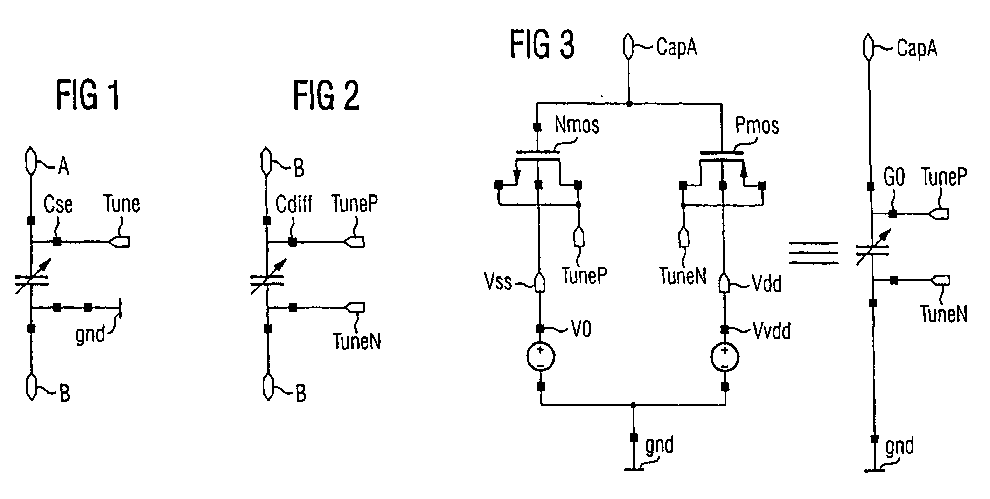

In Fig. 1 ist ein Varaktor dargestellt, dessen Kapazität von einer Spannung zwischen einem Grundpotential (gnd) und einem Eingangssignal Tune abhängt: C = f (V_{Tune}).

Ein erfindungsgemäßer Varaktor ist in Fig. 2 dargestellt. Der Varaktor bildet eine Kapazität C, die von einer Differenz zwischen zwei Spannungen abhängt: C = f (V_{TuneP} - V_{TuneN}).

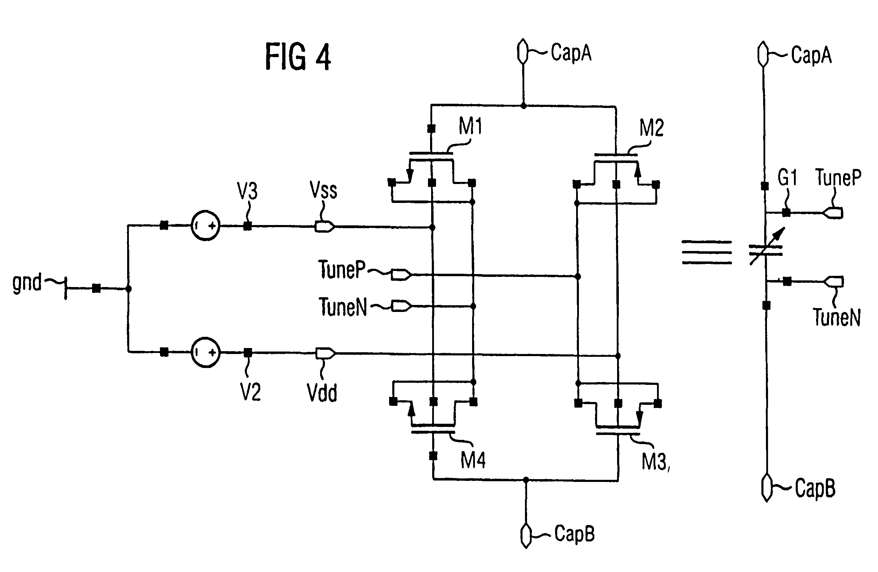

Durch die Parallelschaltung von nMOS- und pMOS-Varaktoren wird erreicht, dass der Varaktor nur noch durch eine Differenzspannung gesteuert wird und dass der Varaktor nicht auf Gleichtaktsignale reagiert. Dies bewirkt eine größere Störunempfindlichkeit und ist besonders vorteilhaft in hochintegrierten Chips (Mixed-Mode Chips). Der differentiell gesteuerte MOS-Varaktor ist schematisch dargestellt in Fig. 3, eine floating Variante ist in Fig. 4 dargestellt.

Die Vorteile der Schaltung liegen in der Integrierbarkeit in CMOS oder BICMOS-Prozesse und in den verbesserten Mixed-Mode Eigenschaften durch die kleinere Störempfindlichkeit von durchgängig differentiellen Signalwegen.

Die dargestellten vorteilhaften Ausführungsformen der Erfindung beinhalten eine Verschaltung von nMOS- und pMOS-Kapazitäten.

## Patentansprüche

1. Spannungsgesteuerte Kapazität,
**dadurch gekennzeichnet, dass** sie zwei parallel geschaltete Varaktoren (M₁-M₄) enthält, die so geschaltet sind, dass die Kapazität durch Differenzsignale (TuneN, TuneP) gesteuert wird.

2. Spannungsgesteuerte Kapazität nach Anspruch 1,
**dadurch gekennzeichnet, dass** die Kapazität durch Differenzsignale zwischen den beiden Varaktoren gesteuert wird.

3. Spannungsgesteuerte Kapazität nach einem oder beiden der Ansprüche 1 oder 2,
**dadurch gekennzeichnet, dass** der eine Varaktor eine nMOS-Schichtenfolge enthält und dass der andere der Varaktoren eine pMOS-Schichtenfolge enthält.

4. Spannungsgesteuerte Kapazität nach Anspruch 3,
**dadurch gekennzeichnet, dass** sie in CMOS und BiCMOS-Schaltungstechnik ausgeführt ist.

## Claims

1. Voltage-controlled capacitance,
**characterized in that** it contains two varactors (M₁-M₄) which are connected in parallel and are connected in such a manner that the capacitance is controlled by means of differential signals (TuneN, TuneP).

2. Volcage-controlled capacitance according to Claim 1,
**characterized in that** the capacitance is controlled by means of differential signals between the two varactors.

3. Voltage-controlled capacitance according to either or both of Claims 1 and 2,
**characterized in that** one varactor contains an nMOS layer sequence, and **in that** the other varactor contains a pMOS layer sequence.

4. Voltage-controlled capacitance according to Claim 3,
**characterized in that** it is implemented using CMOS and BICMOS circuit technology.

## Revendications

1. Capacité commandée par la tension,
**caractérisée en ce qu'**elle comporte deux varactors (M₁ à M₄), qui sont montés en parallèle et qui sont montés de façon à ce que la capacité soit commandée par des signaux (Tune N ; Tune P) de différence.

2. Capacité commandée par la tension suivant la revendication 1,
**caractérisée en ce que** la capacité est commandée par des signaux de différence entre les deux varactors.

3. Capacité commandée par la tension suivant l'une ou les deux des revendications 1 ou 2,
**caractérisée en ce que** l'un des varactors comporte une succession de couches nMOS et **en ce que** l'autre des varactors comporte une succession de couches pMOS.

4. Capacité commandée par la tension suivant la revendication 3,
**caractérisée en ce que** l'elle est réalisée en technique de circuit CMOS et BiCMOS.
